(19) Europäisches Patentamt
European Patent Office
Office européen des brevets

(11) **EP 4 686 371 A1**

(12) **EUROPEAN PATENT APPLICATION**
published in accordance with Art. 153(4) EPC

(43) Date of publication:
**28.01.2026 Bulletin 2026/05**

(21) Application number: **23928799.8**

(22) Date of filing: **19.12.2023**

(51) International Patent Classification (IPC):
*H10N 30/853* (2023.01)   *C23C 14/08* (2006.01)
*C23C 14/58* (2006.01)   *H10N 30/20* (2023.01)
*H10N 30/076* (2023.01)   *H10N 30/082* (2023.01)

(52) Cooperative Patent Classification (CPC):
H10N 30/076; C23C 14/08; C23C 14/58;
H10N 30/079; H10N 30/2047; H10N 30/708;
H10N 30/8542

(86) International application number:
**PCT/JP2023/045475**

(87) International publication number:
**WO 2024/195233 (26.09.2024 Gazette 2024/39)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **23.03.2023 JP 2023047182**

(71) Applicant: **Sumitomo Chemical Company, Limited
Tokyo 103-6020 (JP)**

(72) Inventors:
• **KURODA, Toshiaki**
  **Hitachi-shi, Ibaraki 319-1418 (JP)**
• **SHIBATA, Kenji**
  **Hitachi-shi, Ibaraki 319-1418 (JP)**
• **WATANABE, Kazutoshi**
  **Hitachi-shi, Ibaraki 319-1418 (JP)**

(74) Representative: **Vossius & Partner
Patentanwälte Rechtsanwälte mbB
Siebertstrasse 3
81675 München (DE)**

(54) **PIEZOELECTRIC MULTILAYER BODY, PIEZOELECTRIC MULTILAYER WAFER, AND METHOD FOR PRODUCING PIEZOELECTRIC MULTILAYER BODY**

(57)    A piezoelectric stack including: a substrate; a piezoelectric film deposited on the substrate, the piezoelectric film being constituted from an alkali niobium oxide, the alkali niobium oxide containing potassium, sodium, niobium, and oxygen and having a perovskite structure; and a top electrode deposited on the piezoelectric film, wherein in a case in which the piezoelectric stack is subjected to a heat treatment at 400 °C for 15 minutes in an atmospheric environment and then observed, no detachment having a circle equivalent diameter of 30 µm or more is observed at a boundary between the piezoelectric film and the top electrode.

FIG. 1

10 (10A)

## Description

Technical Field

The present disclosure relates to a piezoelectric stack, a piezoelectric stacked wafer, and a piezoelectric stack manufacturing method.

Background Art

Piezoelectric substances are widely used in functional electronic components such as sensors and actuators. KNN-based ferroelectric materials containing potassium, sodium, niobium, and oxygen are used as a type of material for the piezoelectric substances, and a stack has been proposed that has a piezoelectric film (KNN film) deposited using such a piezoelectric substance and a top electrode deposited on the KNN film (see, for example, Patent documents 1 and 2).

Citation List

Patent document

[Patent Document 1] Japanese Patent Application Laid-Open Publication No. 2017-076730

[Patent Document 2] Japanese Patent Application Laid-Open Publication No. 2008-159807

Summary of the Invention

Technical Problem

When a conventional stack having a piezoelectric film (KNN film) and a top electrode is heated under a designated condition (for example, a designated temperature), partial detachment may occur at the boundary between the KNN film and the top electrode.
An objective of the present disclosure is to provide, inter alia, a stack with a piezoelectric film, which suppresses the occurrence of partial detachment at the boundary between the piezoelectric film and the top electrode, even when heated under designated conditions.

Solution to Problem

According to an embodiment of the present disclosure, provided is a piezoelectric stack including:

a substrate;
a piezoelectric film deposited on the substrate, the piezoelectric film being constituted from an alkali niobium oxide, the alkali niobium oxide containing potassium, sodium, niobium, and oxygen and having a perovskite structure; and
a top electrode deposited on the piezoelectric film, wherein
in a case in which the piezoelectric stack is subjected to a heat treatment at 400 °C for 15 minutes in an atmospheric environment and then observed, no detachment having a circle equivalent diameter of 30 $\mu$m or more is observed at a boundary between the piezoelectric film and the top electrode.

According to another embodiment of the present disclosure, provided is a piezoelectric stack including:

a substrate;
a piezoelectric film deposited on the substrate, the piezoelectric film being constituted from an alkali niobium oxide, the alkali niobium oxide containing potassium, sodium, niobium, and oxygen and having a perovskite structure; and
a top electrode deposited on the piezoelectric film, wherein
in a case in which the piezoelectric stack is subjected to a heat treatment at 400 °C for 15 minutes in an atmospheric environment, and then a top face of the top electrode is observed with a differential interference contrast microscope in a field of view of 400 $\mu$m $\times$ 400 $\mu$m, the number of detachments each having a circle equivalent diameter of 10 $\mu$m or more is no more than 20 in the field of view.

According to another embodiment of the present disclosure, provided is a piezoelectric stacked wafer including:

a substrate having a diameter of 100 mm or more;
a piezoelectric film deposited on the substrate, the piezoelectric film being constituted from an alkali niobium oxide, the alkali niobium oxide containing potassium, sodium, niobium, and oxygen and having a perovskite structure; and
a top electrode deposited on the piezoelectric film, wherein
in a case in which the piezoelectric stacked wafer is subjected to a heat treatment at 400 °C for 15 minutes in an atmospheric environment and then observed, no detachment having a circle equivalent diameter of 30 $\mu$m or more is observed at a boundary between the piezoelectric film and the top electrode in an area other than an area that is 5 mm from the outer periphery of the substrate.

According to another embodiment of the present disclosure, provided is a piezoelectric stack manufacturing method including:

preparing a substrate on which a piezoelectric film has been deposited, the piezoelectric film being constituted from an alkali niobium oxide containing potassium, sodium, niobium, and oxygen;
applying a photoresist to a surface of the piezoelectric film;
removing the photoresist from the surface of the piezoelectric film; and
depositing a top electrode on the surface of the piezoelectric film after the photoresist is removed.

Advantage of the Invention

According to the present disclosure, even when a stack with a piezoelectric film is heated under designated conditions, the occurrence of partial detachment at the boundary between the piezoelectric film and the top electrode can be suppressed.

Brief Description of the Drawings

[FIG. 1] FIG. 1 is a diagram illustrating an example of a cross-sectional structure of a stacked wafer and a piezoelectric stack according to an embodiment of the present disclosure.
[FIG. 2] FIG. 2 is a diagram illustrating an example of an outline of a piezoelectric element (MEMS device) according to an embodiment of the present disclosure.
[FIG. 3] FIG. 3 is a diagram illustrating an example of an outline of a piezoelectric device module according to an embodiment of the present disclosure.
[FIG. 4] FIG. 4 is a differential interference contrast image obtained by observing the top face of the top electrode (film) in an arbitrary field of view of an area other than a 5 mm area from the outer periphery of the substrate of Sample 1 with a differential interference contrast microscope.
[FIG. 5] FIG. 5(a) is a differential interference contrast image obtained by observing the top face of the top electrode (film) in an arbitrary field of view of an area other than a 5 mm area from the outer periphery of the substrate of Sample 2 with a differential interference contrast microscope, FIG. 5(b) is an FIB-SEM image of a location where detachment occurred in Sample 2, and FIG. 5(c) is an FIB-SEM longitudinal cross-sectional image of line A-A in FIG. 5(b).
[FIG. 6] FIG. 6 is a differential interference contrast image obtained by observing the top face of the top electrode (film) in an arbitrary field of view of an area other than a 5 mm area from the outer periphery of the substrate of Sample 3 with a differential interference contrast microscope.
[FIG. 7] FIG. 7 is a differential interference contrast image obtained by observing the top face of the top electrode (film) in an arbitrary field of view of an area other than a 5 mm area from the outer periphery of the substrate of Sample 4 with a differential interference contrast microscope.
[FIG. 8] FIG. 8 is a differential interference contrast image obtained by observing the top face of the top electrode (film) in an arbitrary field of view of the piezoelectric stack obtained from Sample 1 with a differential interference contrast microscope.

Detailed Description of the Invention

<Embodiments of Present Disclosure>

Hereinafter, embodiments of the present disclosure will be described with reference to the drawings.

(1) Structures of Piezoelectric Stacked Wafer and Piezoelectric Stack

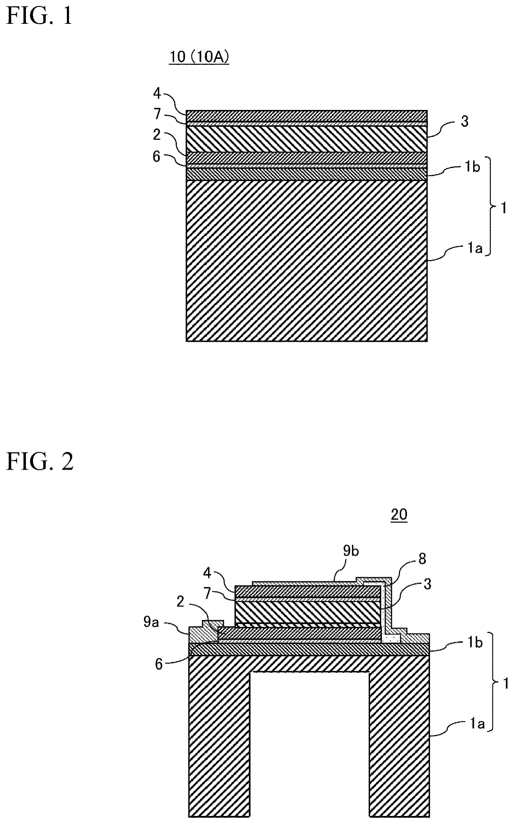

As illustrated in FIG. 1, a wafer 10 (piezoelectric stacked wafer 10, hereinafter also referred to as simply "stacked wafer 10") having a piezoelectric film according to this embodiment includes a substrate 1, a bottom electrode film 2 deposited on the substrate 1, a piezoelectric film (piezoelectric thin film) 3 deposited on the bottom electrode film 2, and a top electrode film 4 deposited on the piezoelectric film 3 via an adhesion layer 7.

As the substrate 1, a single crystal silicon (Si) substrate 1a on which a surface oxide film ($SiO_2$ film) 1b such as a thermal oxide film or a chemical vapor deposition (CVD) oxide film is formed, i.e., a Si substrate having a surface oxide film, can be suitably used. As the substrate 1, a Si substrate 1a having, instead of the surface oxide film 1b, an insulating film formed from an insulating material other than $SiO_2$ can also be used. Alternatively, as the substrate 1, a Si substrate 1a with an exposed Si(100) or Si(111), etc., on the surface, i.e., a Si substrate having no surface oxide film 1b or insulating film, can be used. As the substrate 1, a silicon on insulator (SOI) substrate, a quartz glass ($SiO_2$) substrate, a gallium arsenide (GaAs) substrate, a sapphire ($Al_2O_3$) substrate, or a metal substrate formed from a metal material such as stainless steel (SUS) can also be used. The diameter of the substrate 1 is 100 mm or more. The single crystal Si substrate 1a may have a thickness of, for example, 300 $\mu$m or more and 1000 $\mu$m or less, and the surface oxide film 1b may have a thickness of, for example, 1 nm or more and 4000 nm or less.

The bottom electrode film 2 can be formed by using, for example, platinum (Pt). The bottom electrode film 2 is a polycrystalline film. Hereinafter, a polycrystalline film deposited by using Pt is also referred to as a Pt film. It is preferable that the (111) of the Pt film is parallel to the main face of the substrate 1 (including a case where the (111) is inclined at an angle of $\pm 5°$ or less with respect to the main face of the substrate 1), that is, the Pt film is oriented in the (111) direction. The Pt film being oriented in the (111) direction means that no peaks other than those due to the (111) are observed in the X-ray diffraction pattern obtained by X-ray diffraction (XRD) measured on the surface of the piezoelectric film 3. Thus, it is preferable that the main face of the bottom electrode film 2 (the surface serving as the base of the piezoelectric film 3) is constituted by the Pt (111). The bottom electrode film 2 can be deposited by a method such as sputtering or evaporation method. The bottom electrode film 2 can be formed using, instead of Pt, various metals such as gold (Au), ruthenium (Ru), or iridium (Ir), alloys mainly composed of these metals, or metal oxides such as strontium ruthenium oxide ($SrRuO_3$, abbreviated as SRO) or lanthanum nickel oxide ($LaNiO_3$, abbreviated as LNO). When the bottom electrode film 2 is deposited using these metal oxides, it is preferable that the crystals constituting the bottom electrode film 2 are preferentially oriented in the (001) direction with respect to the surface of the substrate 1. The bottom electrode film 2 can be a single layer film formed using the above-mentioned various metals, alloys mainly composed of the above-mentioned various metals, or metal oxides. The bottom electrode film 2 can be a stack of a Pt film and a film mainly composed of SRO provided on the Pt film, or a stack of a Pt film and a film mainly composed of LNO and provided on the Pt film, or the like. The thickness of the bottom electrode film 2 (the total thickness of the layers when the bottom electrode film 2 is a stack) may be, for example, 100 nm or more and 400 nm or less.

An adhesion layer 6 may be provided between the substrate 1 and the bottom electrode film 2 to enhance adhesion therebetween. The adhesion layer 6 may be, for example, a layer containing zinc (Zn) and oxygen (O) as main components (hereinafter also referred to as a "ZnO layer"). The ZnO layer may be formed using, for example, zinc oxide. The composition ratio of Zn and O constituting the ZnO layer preferably satisfies the relationship Zn:O=1:1, but this is not limiting and there may be slight variations. The ZnO layer is a polycrystalline layer. It is preferable that the (0001) of the ZnO layer is parallel to the main face of the substrate 1 (including a case where the (0001) is inclined at an angle of $\pm 5°$ or less with respect to the main face of the substrate 1), that is, the ZnO layer is oriented in the (0001) direction. The ZnO layer being oriented in the (0001) direction means that the intensity of a peak due to the (0002) is high in the X-ray diffraction pattern obtained by XRD measured on the surface of the piezoelectric film 3. Thus, the main face of the ZnO layer (the surface serving as the base of the bottom electrode film 2) is preferably constituted by the ZnO (0001). The ZnO layer can be deposited by a method such as sputtering or evaporation method. The thickness of the ZnO layer may be, for example, 1 nm or more and 200 nm or less, preferably 10 nm or more and 50 nm or less. The adhesion layer 6 may be a layer mainly composed of titanium (Ti), tantalum (Ta), titanium oxide ($TiO_2$), nickel (Ni), ruthenium oxide ($RuO_2$), iridium oxide ($IrO_2$), etc., instead of ZnO. Such an adhesion layer 6 can also be deposited by a method such as sputtering or evaporation method, and the thickness of the adhesion layer 6 may be, for example, 1 nm or more and 200 nm or less, preferably 10 nm or more and 50 nm or less. In this specification, the adhesion layer 6 provided between the substrate 1 and the bottom electrode film 2 is also referred to as a bottom adhesion layer 6.

The piezoelectric film 3 is a film formed from, for example, an alkali niobium oxide containing potassium (K), sodium (Na), niobium (Nb), and oxygen (O). That is, the piezoelectric film 3 is a film mainly composed of an alkali niobium oxide containing K, Na, Nb, and O. The piezoelectric film 3 can be formed using an alkali niobium oxide represented by the composition formula $(K_{1-x}Na_x)NbO_3$, that is, potassium sodium niobate (KNN). The coefficient x [=Na/(K+Na)] in the above composition formula can be within the range of 0<x<1, preferably $0.4 \leq x \leq 0.8$. The piezoelectric film 3 is a polycrystalline film of KNN (hereinafter also referred to as a KNN film 3). The crystal structure of KNN is a perovskite structure. That is, the KNN film 3 has a perovskite structure. In addition, it is preferable that at least half of the crystals in the crystal group constituting the KNN film 3 have a columnar structure. In this specification, the crystal system of KNN will be regarded as a tetragonal system. The KNN film 3 can be deposited by a method such as sputtering, a pulsed laser deposition (PLD) method, or a sol-gel method. The thickness of the KNN film 3 may be, for example, 0.5 $\mu$m or more and 5 $\mu$m or less, preferably 1 $\mu$m or more and 3 $\mu$m or less.

The crystals constituting the KNN film 3 are preferentially oriented in the (001) direction with respect to the main face of the substrate 1 (Si substrate 1a when the substrate 1 is, for example, a Si substrate 1a having a surface oxide film 1b or an insulating film). That is, the main face of the KNN film 3 (the surface that serves as the base of the top electrode film 4) is mainly composed of the KNN (001). For example, by directly depositing the KNN film 3 on the Pt film (bottom electrode film 2) whose main face is mainly composed of the Pt (111), the KNN film 3 whose main face is mainly composed of the KNN (001) can be obtained.

In this specification, the crystals constituting the KNN film 3 being oriented in the (001) direction means that the (001) of the crystals constituting the KNN film 3 is parallel or approximately parallel to the main face of the substrate 1. In addition, the crystals constituting the KNN film 3 being preferentially oriented in the (001) direction means that there are many crystals whose (001) is parallel or approximately parallel to the main face of the substrate 1. For example, it is preferable that 80 % or more of the crystals constituting the KNN film 3 are oriented in the (001) direction with respect to the main face of the substrate 1. That is, the orientation rate of the crystals constituting the KNN film 3 to the (001) direction (also referred to as the "(001) orientation rate" in this specification) is, for example, preferably 80 % or more, more preferably 90 % or more. Note that the "(001) orientation rate" in this specification is a value calculated by the following formula (1) based on the peak intensity of the X-ray diffraction pattern ($2\theta/\theta$) obtained by performing XRD measurement on the KNN film 3.

(001) orientation rate (%) = {(001) peak intensity / ((001) peak intensity+(110) peak intensity)} $\times$ 100      (Formula (1))

The "(001) peak intensity" in the above formula (1) is the intensity of a diffraction peak due to crystals oriented in the (001) direction (i.e., crystals whose (001) are parallel to the main face of the substrate 1) among the crystals constituting the KNN film 3 in the X-ray diffraction pattern obtained by performing XRD measurement on the KNN film 3, and is the intensity of a peak that appears within a $2\theta$ range of 20° to 23°. In addition, when multiple peaks appear within the $2\theta$ range of 20° to 23°, the intensity is that of the highest peak. Furthermore, the "(110) peak intensity" in the above formula (1) is the intensity of a diffraction peak due to crystals oriented in the (110) direction (i.e., crystals whose (110) are parallel to the main face of the substrate 1) among the crystals constituting the KNN film 3 in the X-ray diffraction pattern obtained by performing XRD measurement on the KNN film 3, and is the intensity of a peak that appears within a $2\theta$ range of 30° to 33°. When multiple peaks appear within the $2\theta$ range of 30° to 33°, the intensity is that of the highest peak.

The alkali niobium oxide constituting the KNN film 3 may further contain at least one element (dopant) selected from the group consisting of lithium (Li), magnesium (Mg), calcium (Ca), strontium (Sr), barium (Ba), bismuth (Bi), antimony (Sb), vanadium (V), indium (In), tantalum (Ta), molybdenum (Mo), tungsten (W), chromium (Cr), Ti, zirconium (Zr), hafnium (Hf), scandium (Sc), yttrium (Y), lanthanum (La), cerium (Ce), praseodymium (Pr), neodymium (Nd), samarium (Sm), europium (Eu), gadolinium (Gd), terbium (Tb), dysprosium (Dy), holmium (Ho), erbium (Er), thulium (Tm), ytterbium (Yb), lutetium (Lu), copper (Cu), zinc (Zn), silver (Ag), manganese (Mn), iron (Fe), cobalt (Co), Ni, aluminum (Al), Si, germanium (Ge), tin (Sn), and gallium (Ga). The concentration of these elements in the alkali niobium oxide may be, for example, 5 at% or less (when a plurality of the above elements are contained, the total concentration is to be 5 at% or less).

The top electrode film 4 is mainly composed of various metals such as Pt, Au, Al, Cu, etc., or an alloy thereof. The top electrode film 4 can be deposited by a method such as sputtering, an evaporation method, a plating method, a metal paste method, etc. The top electrode film 4 does not have a large effect on the crystal structure of the KNN film 3, unlike the bottom electrode film 2. Therefore, the material, crystal structure, and deposition method of the top electrode film 4 are not particularly limited. The thickness of the top electrode film 4 may be, for example, 50 nm or more and 5000 nm or less, preferably 50 nm or more and 300 nm or less.

An adhesion layer 7 mainly composed of, for example, Ti, Ta, $TiO_2$, Ni, $RuO_2$, $IrO_2$, etc. is provided between the KNN film 3 and the top electrode film 4 to enhance adhesion therebetween. The adhesion layer 7, similarly to the top electrode film 4, does not have a significant effect on the crystal structure of the KNN film 3. Therefore, the material, crystal structure, and deposition method of the adhesion layer 7 are not particularly limited. The adhesion layer 7 can be deposited by a method such as sputtering, an evaporation method, a plating method, or a metal paste method. The thickness of the adhesion layer 7 may be, for example, 1 nm or more and 200 nm or less, preferably 5 nm or more and 50 nm or less. In this specification, the adhesion layer 7 provided between the KNN film 3 and the top electrode film 4 is also referred to as the top adhesion layer 7.

In this embodiment, the stack of the top adhesion layer 7 and the top electrode film 4 is considered as the top electrode.

Although the details will be described later, the stacked wafer 10 in this embodiment is prepared through a novel method in which the KNN film 3 is deposited, a photoresist is applied to the surface of the KNN film 3, the photoresist is removed from the surface of the KNN film 3 (without patterning the photoresist), and the top adhesion layer 7 and the top electrode film 4 are deposited on the surface of the KNN film 3 after the photoresist is removed. This makes it less likely for partial detachment to occur at the boundary between the KNN film 3 and the top adhesion layer 7 in an area other than a 5 mm area from the outer periphery of the substrate 1 (an area further on the inner side than the area that is 5 mm from the edge of the substrate 1) even when the stacked wafer 10 is heated under designated conditions. As a result, the stacked wafer 10 in this embodiment has Feature 1 described later. In addition, the piezoelectric stack 10A having a designated shape (e.g., a chip shape of 20 mm × 20 mm) obtained from an area other than the 5 mm area from the outer periphery of the substrate 1 of the stacked wafer 10 may have at least one of Features 2 and 3 described later.

The following describes novel features of the stacked wafer 10 of this embodiment and novel features that the piezoelectric stack 10A may have.

(Feature 1)

One of the features of the stacked wafer 10 is that, in a case in which the stacked wafer 10 is observed after a heat treatment at 400 °C for 15 minutes in an atmospheric environment, no detachment having a circle equivalent diameter of 30 $\mu$m or more is observed at the boundary between the KNN film 3 and the top adhesion layer 7 in an area other than a 5 mm area from the outer periphery of substrate 1.

The circle equivalent diameter is the diameter of a circle having an area equal to the cross-sectional area of a detachment. The detachments were observed by observing the top face of the top electrode film 4 of the stacked wafer 10 after the heat treatment with a differential interference contrast microscope. The "top face of the top electrode film 4" here refers to, of the two main faces of the top electrode film 4, the surface opposite from the surface on the KNN film 3 side. This applies also the following explanations.

The presence of a detachment (e.g., a portion of the surface raised by the generation of an air bubble) having a circle equivalent diameter of 30 $\mu$m or more is a factor in reducing the adhesion between the KNN film 3 and the top adhesion layer 7. In this embodiment, by adopting the novel method above, even when the stacked wafer 10 is heated under designated conditions, the emergence of detachment (partial detachment) having a circle equivalent diameter of 30 $\mu$m or more at the boundary between the KNN film 3 and the top adhesion layer 7 is suppressed in an area other than a 5 mm area from the outer periphery of the substrate 1 of the stacked wafer 10, and the reduction in adhesion between the KNN film 3 and the top adhesion layer 7 is successfully avoided. Accordingly, the life of the stacked wafer 10 can be extended, and in turn, the life of the piezoelectric element 20 and the piezoelectric device module 30, which will be described later, obtained by processing the piezoelectric stack 10A can be extended. Moreover, the manufacturing yield and reliability of the piezoelectric element 20 and the piezoelectric device module 30 can be improved.

(Feature 2)

One of possible features of the piezoelectric stack 10A is that when the piezoelectric stack 10A is observed after a heat treatment at 400 °C for 15 minutes in an atmospheric environment, no detachment having a circle equivalent diameter of 30 $\mu$m or more is observed at the boundary between the KNN film 3 and the top adhesion layer 7.

In this embodiment, even when the piezoelectric stack 10A is heated under designated conditions, the emergence of detachment (partial detachment) having a circle equivalent diameter of 30 $\mu$m or more at the boundary between the KNN film 3 and the top adhesion layer 7 is suppressed, and a decrease in adhesion between the KNN film 3 and the top adhesion layer 7 is successfully avoided. Accordingly, the life of the piezoelectric element 20 and the piezoelectric device module 30, which will be described later, obtained by processing the piezoelectric stack 10A, can be extended. Moreover, the manufacturing yield and reliability of the piezoelectric element 20 and the piezoelectric device module 30 can be improved.

(Feature 3)

One of possible features of the piezoelectric stack 10A is that, when the top face of the top electrode film 4 of the piezoelectric stack 10A after a heat treatment at 400 °C for 15 minutes in an atmospheric environment is observed with a differential interference contrast microscope in an arbitrary field of view of 400 $\mu$m × 400 $\mu$m, the number of detachments each having a circle equivalent diameter of 10 $\mu$m or more within the field of view is no more than 20.

In the piezoelectric stack 10A after the heat treatment under the designated condition, detachments (partial detachments) each having a circle equivalent diameter of 10 $\mu$m or more may be observed, but the number of detachments is very small, no more than 20 in an arbitrary field of view of 160,000 $\mu$m$^2$. Thus, in this embodiment, even when the piezoelectric stack 10A is heated under designated conditions, the emergence of detachments each having a circle equivalent diameter of 10 $\mu$m or more at the boundary between the KNN film 3 and the top adhesion layer 7 is suppressed, and a decrease in adhesion between the KNN film 3 and the top adhesion layer 7 is successfully avoided. Accordingly, the life of the piezoelectric element 20 and the piezoelectric device module 30, described later, obtained by processing the piezoelectric stack 10A, can be extended. Moreover, the manufacturing yield and reliability of the piezoelectric element 20 and the piezoelectric device module 30 can be improved.

(2) Method for manufacturing stacked wafer, piezoelectric stack, piezoelectric element, and piezoelectric device module

Next, a method for manufacturing the stacked wafer 10, the piezoelectric stack 10A, the piezoelectric element 20, and the piezoelectric device module 30 according to this embodiment will be described.

(Depositing Bottom Adhesion Layer and Bottom Electrode Film)

First, a substrate 1 having a diameter of 100 mm or more is prepared, and a bottom adhesion layer 6 (e.g., a ZnO layer) and a bottom electrode film 2 (e.g., a Pt film) are deposited in this order by, for example, sputtering, on one of the main faces of the substrate 1. Note that a substrate 1 on which the bottom adhesion layer 6 and the bottom electrode film 2 have been previously deposited on one of the main faces may be prepared instead.

The following are examples of conditions for depositing the ZnO layer as the bottom adhesion layer 6. The deposition time of the bottom adhesion layer 6 is appropriately adjusted depending on the target thickness of the bottom adhesion layer 6.

Target: ZnO sintered ceramics
Temperature (substrate temperature): 200 °C or higher and 700 °C or lower, preferably 300 °C or higher and 700 °C or lower, more preferably 500 °C or higher and 700 °C or lower
RF-power density: 2 W/cm$^2$ or more and 6 W/cm$^2$ or less, preferably 3 W/cm$^2$ or more and 5 W/cm$^2$ or less
Atmosphere: mixed gas atmosphere of argon (Ar) gas and oxygen (O$_2$) gas (hereinafter also referred to as "Ar/O$_2$ mixed gas atmosphere")
Ratio of partial pressure of Ar gas to O$_2$ gas (Ar gas partial pressure/O$_2$ gas partial pressure): 5/1 to 30/1, preferably 7/1 to 20/1, more preferably 10/1 to 15/1
Atmospheric pressure: 0.1 Pa or more and 0.5 Pa or less, preferably 0.2 Pa or more and 0.4 Pa or less
Thickness: 1 nm or more and 200 nm or less, preferably 10 nm or more and 50 nm or less

In this specification, when a numerical range is expressed, such as "5/1 to 30/1", it means that the lower limit and the upper limit are included in the range. The same applies to other numerical ranges.
The following are examples of conditions for depositing a Ti layer or the like as the bottom adhesion layer 6.

Target: Ti plate, etc.
Temperature (substrate temperature): 100 °C or higher and 500 °C or lower, preferably 200 °C or higher and 400 °C or lower
Atmosphere: Ar gas atmosphere
Atmospheric pressure: 0.1 Pa or more and 0.5 Pa or less, preferably 0.2 Pa or more and 0.4 Pa or less

The other conditions may be similar to those for when depositing the ZnO layer.
The following are examples of conditions for depositing a Pt film as the bottom electrode film 2. The deposition time of the bottom electrode film 2 is appropriately adjusted according to the target thickness of the bottom electrode film 2.

Target: Pt plate
Temperature (substrate temperature): 200 °C or higher and 600 °C or lower, preferably 300 °C or higher and 500 °C or lower
RF-power density: 1 W/cm$^2$ or more and 5 W/cm$^2$ or less, preferably 2 W/cm$^2$ or more and 4 W/cm$^2$ or less
Atmosphere: Ar gas atmosphere
Atmospheric pressure: 0.1 Pa or more and 0.5 Pa or less, preferably 0.2 Pa or more and 0.4 Pa or less
Thickness: 100 nm or more and 400 nm or less

(Depositing KNN Film)

After the deposition of the bottom adhesion layer 6 and the bottom electrode film 2 is completed, the KNN film 3 is deposited on the bottom electrode film 2 by a sputtering method such as RF magnetron sputtering. The composition of the KNN film 3 can be adjusted by controlling the composition of the target used during sputtering deposition, for example. The target can be prepared by mixing $K_2CO_3$ powder, $Na_2CO_3$ powder, $Nb_2O_5$ powder, etc., and baking them. The composition of the target can be controlled by adjusting the mixing ratio of the $K_2CO_3$ powder, $Na_2CO_3$ powder, $Nb_2O_5$ powder, etc. In a case of depositing the KNN film 3 containing the above-mentioned elements such as Cu or Mn, a target in which Cu powder (or CuO powder), Mn powder (or MnO powder), etc., are mixed in the designated ratio in addition to the above-mentioned powders may be used.

The following are examples of conditions for depositing the KNN film 3. The deposition time of the KNN film 3 is appropriately adjusted according to the target thickness of the KNN film 3.

RF-power density: 2.7 $W/cm^2$ or more and 4.1 $W/cm^2$ or less, preferably 2.8 $W/cm^2$ or more and 3.8 $W/cm^2$ or less
Temperature (substrate temperature): 350 °C or higher and 800 °C or lower, preferably 400 °C or higher and 780 °C or lower
Atmosphere: Atmosphere containing at least Ar gas, preferably $Ar/O_2$ mixed gas atmosphere
Atmospheric pressure: 0.03 Pa or more and 0.5 Pa or less, preferably 0.04 Pa or more and 0.4 Pa or less
Ratio of partial pressure of $O_2$ gas to Ar gas ($O_2$ gas partial pressure/Ar gas partial pressure): 0 to 1/20, preferably 0 to 1/30
Deposition rate: 0.5 $\mu$m/hr or higher and 4 $\mu$m/hr or lower, preferably 0.5 $\mu$m/hr or higher and 2 $\mu$m/hr or lower
Thickness of KNN film: 0.5 $\mu$m or more and 5 $\mu$m or less, preferably 1 $\mu$m or more and 3 $\mu$m or less

The concept of "$O_2$ gas partial pressure/Ar gas partial pressure being 0 (zero)" means a state in which the $O_2$ gas partial pressure is 0, that is, a case in which the atmosphere is only Ar gas.

(Applying Photoresist)

After the deposition of the KNN film 3 is completed, a photoresist is applied to the surface of the KNN film 3. The "surface of the KNN film 3" here refers to the top face of the KNN film 3 (i.e., of the two main faces of the KNN film 3, the surface on the opposite side from the bottom electrode film 2 side). The photoresist is preferably applied to the entire surface of the KNN film 3, that is, to the surface of the KNN film 3 so that the surface is not exposed. The photoresist may be either a negative resist or a positive resist. An example of the photoresist is a novolac-based phenolic resin. The photoresist can be applied to the surface of the KNN film 3 by a method such as spin coating.

The following are examples of conditions for applying the photoresist.

Photoresist: Novolac-based phenolic resin (manufactured by Zeon Corporation, model number: ZPN1150)
Temperature (substrate temperature): Room temperature (25 °C) or higher and 100 °C or lower
Application speed: 1000 rpm or higher and 5000 rpm or lower, preferably 2000 rpm or higher and 4000 rpm or lower
Atmosphere: Atmosphere containing at least $O_2$, e.g., in the air

(Removing Photoresist)

After applying the photoresist to the surface of the KNN film 3, the photoresist is removed (stripped) from the surface of the KNN film 3. Specifically, after applying the photoresist to the surface of the KNN film 3, the photoresist is removed from the surface of the KNN film 3 without patterning the photoresist. As a method for removing (stripping) the photoresist, various known methods can be used, such as a method using plasma, a method using a designated stripping solution, etc. The photoresist may be removed without curing the photoresist (UV curing, heat curing), or after curing the photoresist.

(Depositing Top Adhesion Layer and Top Electrode Film)

After the removal of the photoresist is completed, the top adhesion layer 7 (for example, a $RuO_2$ layer) and the top electrode film 4 (for example, a Pt film) are deposited in this order by, for example, sputtering on the KNN film 3 from which the photoresist has been removed.

The following are examples of conditions for depositing a $RuO_2$ layer or the like as the top adhesion layer 7. The deposition time of the top adhesion layer 7 is appropriately adjusted depending on the target thickness of the top adhesion layer 7.

Target: Ru plate, etc.
Temperature (substrate temperature): Room temperature (25 °C) or higher and 500 °C or lower
RF-power density: 0.3 $W/cm^2$ or more and 2 $W/cm^2$ or less, preferably 0.5 $W/cm^2$ or more and 1 $W/cm^2$ or less

Atmosphere: Ar/O$_2$ mixed gas atmosphere

Ratio of partial pressure of Ar gas to O$_2$ gas (Ar gas partial pressure/O$_2$ gas partial pressure): 3/5 to 1/1, preferably 3/4 to 1/1

Atmospheric pressure: 0.1 Pa or more and 1.0 Pa or less, preferably 0.2 Pa or more and 0.7 Pa or less

Thickness: 1 nm or more and 200 nm or less, preferably 5 nm or more and 50 nm or less

The following are examples of conditions for depositing a Pt film or the like as the top electrode film 4. The deposition time of the top electrode film 4 is appropriately adjusted according to the target thickness of the top electrode film 4.

Target: Pt plate, etc.

Temperature (substrate temperature): Room temperature (25 °C) or higher and 500 °C or lower

RF-power density: 1 W/cm$^2$ or more and 5 W/cm$^2$ or less, preferably 2 W/cm$^2$ or more and 4 W/cm$^2$ or less

Atmosphere: Ar gas atmosphere

Atmospheric pressure: 0.1 Pa or more and 0.5 Pa or less, preferably 0.2 Pa or more and 0.4 Pa or less

Thickness: 50 nm or more and 5000 nm or less, preferably 50 nm or more and 300 nm or less

In this manner, by depositing the bottom adhesion layer 6, the bottom electrode film 2, the KNN film 3, the top adhesion layer 7, and the top electrode film 4 in this order on the substrate 1, the stacked wafer 10 as illustrated in FIG. 1 is obtained.

In this embodiment, the top adhesion layer 7 and the top electrode film 4 are deposited in this order on the KNN film 3 after the photoresist has been applied and removed. As a result, even when the stacked wafer 10 is heated under a designated condition in a subsequent process, partial detachment less likely to occur at the boundary between the KNN film 3 and the top adhesion layer 7 in an area other than a 5 mm area from the outer periphery of the substrate 1. The mechanism of this has not yet been clarified, but it is a novel finding that was first obtained in the course of intensive investigations by the present inventors.

(Preparing Piezoelectric Stack)

After preparing the stacked wafer 10 as illustrated in FIG. 1, the stacked wafer 10 is processed to prepare the piezoelectric stack 10A having a designated shape (e.g., chip shape). Specifically, the stacked wafer 10 is subjected to cutting or the like to prepare a plurality of piezoelectric stacks 10A from one stacked wafer 10, for example.

In this embodiment, the top adhesion layer 7 and the top electrode film 4 are deposited in this order on the KNN film 3 after the photoresist has been applied and removed. As a result, even when the piezoelectric stack 10A is heated under a designated condition in a subsequent process, partial detachment is less likely to occur at the boundary between the KNN film 3 and the top adhesion layer 7. As described above, this is a new finding that was first obtained in the course of intensive investigations by the present inventors.

(Preparing Piezoelectric Element)

After the piezoelectric stack 10A is prepared, the piezoelectric stack 10A is processed to prepare the piezoelectric element 20 (an element 20 having the KNN film 3).

Specifically, first, the top electrode film 4, the top adhesion layer 7, the KNN film 3, the bottom adhesion layer 6, and the bottom electrode film 2 are each individually patterned by dry etching using, for example, Ar gas or a reactive gas such as CF$_4$ gas. In the patterning, the top electrode film 4, the top adhesion layer 7, and the KNN film 3 are each etched to form them into a designated shape and expose a part of the bottom electrode film 2, and then the bottom electrode film 2 and the bottom adhesion layer 6 are each etched to form them into a designated shape. In the patterning, a photoresist can be used as an etching mask.

Next, the insulating film 8 (see FIG. 2) is provided. Specifically, the insulating film 8 is deposited from the top electrode film 4 to the bottom electrode film 2 so as to cover a part of the side face of the KNN film 3. The insulating film 8 can be formed using silicon oxide (SiO$_2$), aluminum oxide (Al$_2$O$_3$), tantalum oxide (Ta$_2$O$_5$), or the like. The insulating film 8 may be a single layer film or a stack (stack film) in which a plurality of layers are stacked. The insulating film 8 can be deposited by a method such as sputtering or an evaporation method. When a SiO$_2$ film is formed as the insulating film 8, the film can be deposited by, for example, a plasma CVD method using tetraethoxysilane (TEOS) gas.

The following are examples of conditions for depositing an SiO$_2$ film as the insulating film 8 by a plasma CVD method. The deposition time of the insulating film 8 is appropriately adjusted according to the target thickness of the insulating film 8.

Temperature (substrate temperature): 300 °C or higher and 650 °C or lower, preferably 400 °C or higher and 600 °C or lower

Supply gas: TEOS gas and $O_2$ gas

Supply flow rate of TEOS gas: 3 sccm or more and 10 sccm or less, preferably 4 sccm or more and 8 sccm or less

Supply flow rate of $O_2$ gas: 300 sccm or more and 600 sccm or less, preferably 400 sccm or more and 500 sccm or less

RF-power density: 0.3 W/cm$^2$ or more and 10 W/cm$^2$ or less, preferably 0.5 W/cm$^2$ or more and 3 W/cm$^2$ or less

Atmospheric pressure: 0.3 Pa or more and 1.0 Pa or less, preferably 0.5 Pa or more and 0.8 Pa or less

As described above, in this embodiment, in the process of preparing the stacked wafer 10, the top adhesion layer 7 and the top electrode film 4 are deposited in this order on the KNN film 3 after the photoresist has been applied and removed. As a result, partial detachment is less likely to occur at the boundary between the KNN film 3 and the top adhesion layer 7, even when the piezoelectric stack 10A (the substrate 1 thereof) is heated under the aforementioned conditions during the deposition of the insulating film 8. In other words, even when designated processing is performed on the piezoelectric stack 10A while the piezoelectric stack 10A is heated at a temperature of, for example, 400 °C or higher, the emergence of partial detachment at the boundary between the KNN film 3 and the top adhesion layer 7 can be suppressed.

After the insulating film 8 is deposited, the insulating film 8 is patterned by dry etching using Ar gas or a reactive gas such as $CF_4$ gas, or by wet etching.

After patterning the insulating film 8, layers composed of a material containing metal (metal wiring films) are provided. The metal wiring films can each be formed using, for example, various metals such as Pt, Au, Al, Ti, Cr, etc., or alloys mainly composed of these various metals. The metal wiring films can be provided by a method such as a sputtering method, evaporation method, plating method, metal paste method, etc. The metal wiring films may be a single layer film or a stack (stack film) in which multiple layers are stacked. Then, the metal wiring films are patterned by dry etching using Ar gas or a reactive gas such as $CF_4$ gas, or by wet etching, to form metal wirings 9a and 9b (see FIG. 2). The metal wiring 9a is formed (patterned) so as to be connected to (contact) the bottom electrode film 2 and not connected to (not contact) the top electrode film 4, and the metal wiring 9b is formed so as to be connected to the top electrode film 4 and not connected to the bottom electrode film 2.

Further, a part of the substrate 1 is removed from the back surface side (of the two main faces of the substrate 1, the face on the opposite side from the face on which the bottom electrode film 2 and the like are deposited) by Deep-RIE or wet etching, and a MEMS device structure such as a membrane structure or a cantilever structure is formed in the piezoelectric stack 10A. As a result, a piezoelectric element (membrane-type MEMS piezoelectric element) 20 as illustrated in FIG. 2 is obtained.

The etching conditions for patterning when forming the insulating film 8 and the metal wirings 9a, 9b, and the etching conditions for the substrate 1 when forming a MEMS device structure or the like in the piezoelectric stack 10A can be typical etching conditions used in semiconductor device manufacturing processes as long as the conditions do not deteriorate the insulation properties of the KNN film 3.

(Preparing Piezoelectric Device Module)

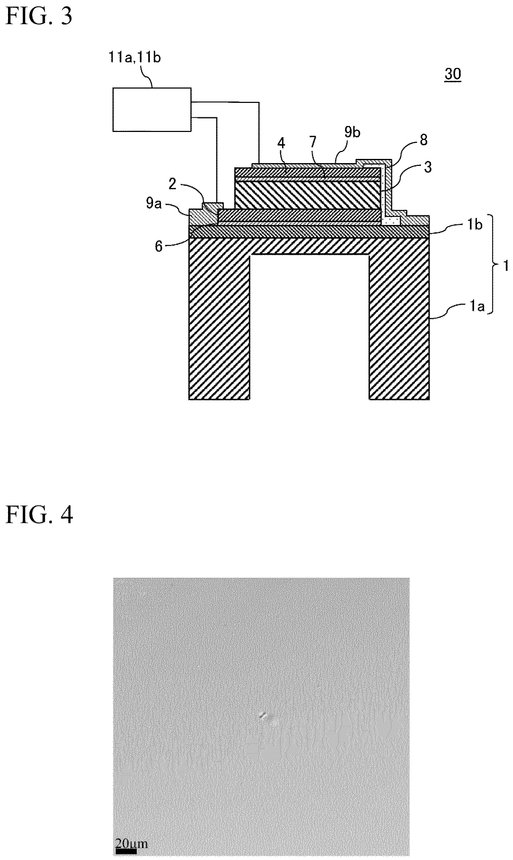

A device module 30 having the KNN film 3 (hereinafter also referred to as a piezoelectric device module 30) is obtained by connecting a voltage detector 11a or a voltage applicator 11b to the obtained piezoelectric element 20. FIG. 3 illustrates an outline diagram of the piezoelectric device module 30 according to this embodiment. The piezoelectric device module 30 includes at least the piezoelectric element 20 and the voltage detector 11a or the voltage applicator 11b connected to the piezoelectric element 20. The voltage detector 11a is means that detects a voltage generated between the bottom electrode film 2 and the top electrode film 4 (between the electrodes). The voltage applicator 11b is means that applies a voltage between the bottom electrode film 2 and the top electrode film 4 (between the electrodes). As the voltage detector 11a and the voltage applicator 11b, various known means can be used.

By connecting the voltage detector 11a between the bottom electrode film 2 and the top electrode film 4 of the piezoelectric element 20, the piezoelectric device module 30 can be made to function as a sensor. When the KNN film 3 deforms in response to a change in some kind of physical quantity, a voltage is generated between the bottom electrode film 2 and the top electrode film 4 due to the deformation. By detecting this voltage with the voltage detector 11a, the magnitude of the physical quantity applied to the KNN film 3 can be measured. In this case, the piezoelectric device module 30 can be used, for example, as an angular velocity sensor, an ultrasonic sensor, a pressure sensor, an acceleration sensor, etc.

By connecting the voltage applicator 11b between the bottom electrode film 2 and the top electrode film 4 of the piezoelectric element 20, the piezoelectric device module 30 can be made to function as an actuator. By applying a voltage between the bottom electrode film 2 and the top electrode film 4 by the voltage applicator 11b, the KNN film 3 can be deformed. With this deformation action, various structures connected to the piezoelectric device module 30 can be made to operate. In this case, the piezoelectric device module 30 can be used, for example, as a head for an inkjet printer, a MEMS mirror for a scanner, a vibrator for an ultrasonic generator, etc.

(3) Effects

According to the embodiments above, one or more of the following effects can be achieved.

(a) The stacked wafer 10 according to this embodiment is prepared through a novel method in which the KNN film 3 is deposited, the photoresist is applied to the top face of the KNN film 3 (without patterning), then the photoresist is removed, and the top adhesion layer 7 and the top electrode film 4 are deposited in this order on the KNN film 3 after the photoresist has been removed.

As a result, even when stacked wafer 10 is heated under designated conditions (e.g., at a temperature of 400 °C or higher), emergence of partial detachment at the boundary between the KNN film 3 and the top adhesion layer 7 can be suppressed in an area other than a 5 mm area from the outer periphery of the substrate 1 of the stacked wafer 10, and a decrease in adhesion between the KNN film 3 and the top adhesion layer 7 can be avoided. As a result, the stacked wafer 10 in this embodiment with Feature 1 above is achieved.

Further, even when the piezoelectric stack 10A in a designated shape obtained from an area other than a 5 mm area from the outer periphery of the substrate 1 of the stacked wafer 10 according to this embodiment is heated under designated conditions (for example, at a temperature of 400 °C or higher), emergence of partial detachment at the boundary between the KNN film 3 and the top adhesion layer 7 can be suppressed, and a decrease in adhesion between the KNN film 3 and the top adhesion layer 7 can be avoided. As a result, the piezoelectric stack 10A in this embodiment with at least one of the Features 2 and 3 above is achieved.

By the stacked wafer 10 with Feature 1 above, or by the piezoelectric stack 10A with at least one of Features 2 and 3 above, even when the stacked wafer 10 is subjected to processes such as a process for depositing the insulating film 8, an annealing process or other such processes according to need, or a heat treatment such as solder reflow for mounting the piezoelectric stack 10A, emergence of partial detachment at the boundary between the KNN film 3 and the top adhesion layer 7 can be suppressed. As a result, a decrease in adhesion between the KNN film 3 and the top adhesion layer 7 can be avoided. As such, the life of the stacked wafer 10, and in turn, the life of the piezoelectric element 20 and the piezoelectric device module 30 obtained by processing the piezoelectric stack 10A, can be extended. In addition, the manufacturing yield and reliability of the piezoelectric element 20 and the piezoelectric device module 30 can also be improved.

(b) The photoresist is preferably applied to the entire surface of the KNN film 3; accordingly, occurrence of partial detachment at the boundary between the KNN film 3 and the top adhesion layer 7 can be reliably suppressed.

(c) The photoresist may be either a negative resist or a positive resist, and the photoresist may be removed without curing the photoresist or after curing the photoresist. In either case, the occurrence of partial detachment at the boundary between the KNN film 3 and the top adhesion layer 7 can be suppressed.

(4) Modifications

The above embodiments can be modified as in the following modifications. In the following modifications, the same components as those in the above aspect are denoted by the same reference symbols, and the description thereof will be omitted. The above embodiments and the following modifications can be combined arbitrarily.

(Modification 1)

In the embodiments above, an example in which the stacked wafer 10 (piezoelectric stack 10A) has the top adhesion layer 7 has been described, but this is not limiting. The stacked wafer 10 may not have the top adhesion layer 7. In other words, the top electrode film 4 may be directly deposited on the KNN film 3. In this modification, the top electrode is formed only from the top electrode film 4.

In this modification too, similar effects to the embodiments above can be obtained by adopting the novel method in which, after depositing the KNN film 3, the photoresist is applied to the top face of the KNN film 3, then the photoresist is removed (without patterning), and the top electrode film 4 is deposited on the KNN film 3 after the photoresist is removed. That is, the stacked wafer 10 with Feature 1 and the piezoelectric stack 10A with at least one of Features 2 and 3 can be obtained.

(Modification 2)

In the embodiments above, an example in which the stacked wafer 10 (piezoelectric stack 10A) includes the bottom electrode film 2 has been described, but this is not limiting. The stacked wafer 10 may not include the bottom electrode film 2. That is, the stacked wafer 10 (piezoelectric stack 10A) may be configured to include the substrate 1, the KNN film (piezoelectric film) 3 deposited on the substrate 1, and the top electrode film 4 (electrode film 4) deposited on the KNN film 3. In this case, the bottom adhesion layer 6 may be provided between the substrate 1 and the KNN film 3, and the top adhesion layer 7 may be provided between the KNN film 3 and the top electrode film 4. With this configuration, the stacked wafer 10, and hence the piezoelectric element 20 (piezoelectric device module 30) obtained by processing the piezoelectric stack 10A, can be made to function as a filter device such as a surface acoustic wave (SAW) filter.

In this modification too, similar effects to the embodiments above can be obtained by adopting the novel method in which, after depositing the KNN film 3, the photoresist is applied to the top face of the KNN film 3 and then removed (without patterning), and the top adhesion layer 7 and the top electrode film 4 are deposited in this order on the KNN film 3 after the photoresist is removed. That is, the stacked wafer 10 with Feature 1 above and the piezoelectric stack 10A with at least one of Features 2 and 3 above can be obtained.

(Modification 3)

When forming the piezoelectric stack 10A above into the piezoelectric element 20, the substrate 1 in the stacked wafer 10 (piezoelectric stack 10A) may be replaced with a different substrate, as long as the piezoelectric device module 30 prepared using the piezoelectric stack 10A (piezoelectric element 20) can be used for the intended purpose, e.g. as a sensor.

<Other Embodiments>

Embodiments of the present disclosure have been described in detail above. However, the present disclosure is not limited to the embodiments and modifications above, and can be modified in various ways without departing from the spirit of the present disclosure. In addition, these aspects can be combined arbitrarily.

In the embodiments and modifications above, a case where the piezoelectric film 3 is a KNN film has been described, but the present disclosure is not limited thereto. The piezoelectric film 3 may be a film containing lead (Pb), zirconium (Zr), and titanium (Ti) (i.e., a film formed using lead zirconate titanate (PZT)), a film containing bismuth (Bi), Na, and Ti (i.e., a film formed using bismuth sodium titanium oxide (BNT)), a film containing bismuth (Bi), Fe, and O (i.e., a film formed using bismuth ferrite (BFO)), a film containing Al and nitrogen (N) (i.e., a film formed using AlN), or the like.

Examples

Hereinafter, experiment results that support the effects of the embodiments above will be described.

(Sample 1)

As the substrate, a Si substrate with a surface in a (100) direction, a thickness of 610 $\mu$m, a diameter of 6 inches (also referred to as "$\varphi$ 6 inches"), and a thermally oxidized film (thickness 200 nm) formed on the surface was prepared. On the thermally oxidized film of this Si substrate, a ZnO layer (thickness 25 nm) as a bottom adhesion layer, a Pt film (preferentially oriented in the (111) direction with respect to the surface of the substrate, and having a thickness 200 nm) as a bottom electrode film, and a KNN film (thickness 2 $\mu$m) as a piezoelectric film were deposited. Then, a negative photoresist (manufactured by Zeon Corporation, model number: ZPN1150) was applied to the surface of the KNN film by spin coating. Then, the photoresist was removed from the surface of the KNN film without curing the photoresist and without patterning the photoresist. The photoresist was removed by immersing the substrate in a developer (manufactured by TOKYO OHKA KOGYO CO., LTD., model number: NMD-W (tetramethylammonium hydroxide (TMAH) 2.38 % solution)) for 5 minutes, and then the substrate was washed with pure water. Then, a $RuO_2$ layer (thickness 10 nm) as a top adhesion layer and a Pt film (thickness 100 nm) as a top electrode film were deposited in this order on the surface of the KNN film from which the photoresist had been removed. In this way, Sample 1, as the stacked wafer, was prepared. In Sample 1, the bottom adhesion layer, bottom electrode film, KNN film, top adhesion layer, and top electrode film were all deposited using an RF magnetron sputtering method.

The conditions for depositing the ZnO layer as the bottom adhesion layer were as follows.

Target: ZnO sintered ceramics
Substrate temperature: 500 °C
RF-power density: 4 W/cm$^2$
Atmosphere: Ar/O$_2$ mixed gas atmosphere
Atmospheric pressure: 0.3Pa

Ar gas partial pressure/$O_2$ gas partial pressure: 10/1
Deposition time: 3 minutes (thickness 25 nm)

The conditions for depositing the Pt film as the bottom electrode film were as follows.

Target: Pt plate
Substrate temperature: 500 °C
RF-power density: 2 W/cm$^2$
Atmosphere: Ar gas atmosphere
Atmospheric pressure: 0.3Pa
Deposition time: 14 minutes (thickness 200 nm)

The conditions for depositing the KNN film were as follows.

Target: KNN sintered ceramics
RF-power density: 3 W/cm$^2$
Atmosphere: Ar/$O_2$ mixed gas atmosphere
Atmospheric pressure : 0.1 Pa
Ar gas partial pressure/$O_2$ gas partial pressure: 20/1
Deposition temperature: 600 °C
Deposition time: 60 minutes (thickness 2 $\mu$m)

The conditions for applying the photoresist onto the KNN film were as follows.

Photoresist: Novolac-based phenolic resin (manufactured by Zeon Corporation, model number: ZPN1150)
Temperature (substrate temperature): room temperature
Application speed: 3000 rpm
Atmosphere: Atmospheric

The conditions for depositing the RuO$_2$ layer as the top adhesion layer were as follows.

Target: Ru plate
Substrate temperature: room temperature (25 °C)
RF-power density: 0.5 W/cm$^2$
Atmosphere: Ar/$O_2$ mixed gas atmosphere
Atmospheric pressure: 0.3 Pa
Ar gas partial pressure/$O_2$ gas partial pressure: 1/1
Deposition time: 6 minutes (thickness 10 nm)

The conditions for depositing the Pt film as the top electrode film were as follows.

Target: Pt plate
Substrate temperature: room temperature (25 °C)
RF-power density: 2 W/cm$^2$
Atmosphere: Ar gas atmosphere
Atmospheric pressure: 0.3 Pa
Deposition time: 7 minutes (thickness 100 nm)

(Sample 2)

As the substrate, a Si substrate with a surface in the (100) direction, a thickness of 610 $\mu$m, $\varphi$ 6 inches, and a thermally oxidized film (thickness 200 nm) formed on the surface was prepared. Then, on the thermally oxidized film of this Si substrate, a ZnO layer (thickness 25 nm) as a bottom adhesion layer, a Pt film (preferentially oriented in the (111) direction with respect to the surface of the substrate, and having a thickness 200 nm) as a bottom electrode film, a KNN film (thickness 2 $\mu$m) as a piezoelectric film, a RuO$_2$ layer (thickness 10 nm) as a top adhesion layer, and a Pt film (thickness 100 nm) as a top electrode film were deposited in this order. In this way, Sample 2, as the stacked wafer, was prepared. In Sample 2, the top adhesion layer was deposited on the KNN film without applying and removing the photoresist, unlike Sample 1. The other procedures and conditions were equivalent to those in Sample 1.

(Sample 3)

In Sample 3, a positive resist (manufactured by TOKYO OHKA KOGYO CO., LTD., model number: OFPR800LB) was used as the photoresist. Other procedures and conditions were equivalent to those for Sample 1, and Sample 3, as the stacked wafer, was prepared.

(Sample 4)

In Sample 4, a Si substrate similar to that of Sample 1 was prepared as the substrate. On the thermally oxidized film of this Si substrate, a ZnO layer as a bottom adhesion layer, a Pt film as a bottom electrode film, and a KNN film as a piezoelectric film were deposited. Then, a negative photoresist (manufactured by Zeon Corporation, model number: ZPN1150) was applied to the surface of the KNN film by spin coating. Then, the substrate was placed on a hot plate heated to 110 °C and was heated for 3 minutes to cure the photoresist. Then, the photoresist was removed from the surface of the KNN film without patterning. Then, a $RuO_2$ layer as a top adhesion layer and a Pt film as a top electrode film were deposited in this order on the surface of the KNN film from which the photoresist had been removed. The photoresist removal method and other procedures and conditions were equivalent to those for Sample 1, and Sample 4, as the stacked wafer, was prepared.

<Evaluation>

Each of Samples 1 to 4 was heated at 400 °C for 15 minutes in an atmospheric environment. Then, after heating, Samples 1 to 4 were evaluated for the presence or absence of detachment (e.g., a portion that has risen due to the generation of air bubbles) having a circle equivalent diameter of 30 μm or more at the boundary between the KNN film and the top adhesion layer. The evaluation for the presence or absence of detachment was performed by observing the top face of each of the top electrode films of Samples 1 to 4 with a differential interference contrast microscope (Digital Microscope DSX-510, manufactured by Olympus Corporation).

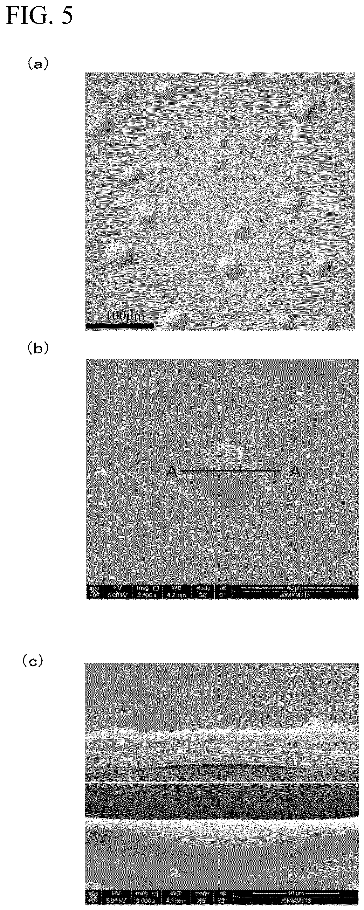

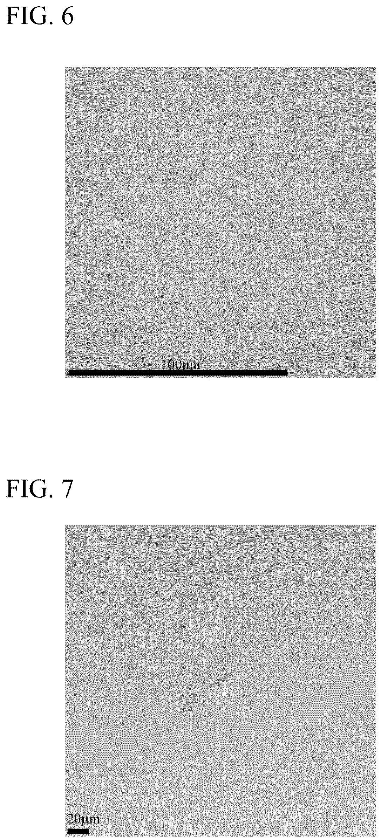

FIG. 4 shows a differential interference contrast image of an arbitrary field of view of an area other than a 5 mm area from the outer periphery of the substrate of Sample 1. FIG. 5(a) shows a differential interference contrast image of an arbitrary field of view of an area other than a 5 mm area from the outer periphery of the substrate of Sample 2, FIG. 5(b) shows an FIB-SEM image of a detachment occurrence location of Sample 2, and FIG. 5(c) shows an FIB-SEM longitudinal cross-sectional image of line A-A in FIG. 5(b). FIG. 6 shows a differential interference contrast image of an arbitrary field of view of an area other than a 5 mm area from the outer periphery of the substrate of Sample 3, and FIG. 7 shows a differential interference contrast image of an arbitrary field of view of an area other than a 5 mm area from the outer periphery of the substrate of Sample 4. Note that the "differential interference contrast image" here means an image obtained by a differential interference contrast microscope.

From FIG. 4, it can be seen that in the stacked wafer of Sample 1, no detachment having a circle equivalent diameter of 30 μm or more is observed in the area other than the 5 mm area from the outer periphery of the substrate. From FIG. 6 and FIG. 7, it can be seen that in the stacked wafers of Samples 3 and 4 too, no detachment having a circle equivalent diameter of 30 μm or more is observed in the area other than the 5 mm area from the outer periphery of the substrate. In addition, in the stacked wafers of Samples 1, 3, and 4, a detachment each having a circle equivalent diameter of 10 μm or more is observed in some cases, but the number of detachments is very small, no more than 20, within an arbitrary field of view of approximately 160,000 $μm^2$.

Meanwhile, from FIG. 5(a), it can be seen that in the stacked wafer of Sample 2, detachment with a circle equivalent diameter of 30 μm or more is observed in the area other than the 5 mm area from the outer periphery of the substrate. From FIG. 5(b) and FIG. 5(c), it can be seen that in the area that has risen due to the generation of air bubbles, the top adhesion layer has detached from the KNN film.

<Evaluating Occurrence of Detachments in Piezoelectric Stack>

Cutting and other processes were performed on Samples 1 to 4 (before heating), and 20 mm × 20 mm piezoelectric stacks were prepared from the areas of the stacked wafer substrates of Samples 1 to 4 other than the 5 mm area from the outer periphery. Each piezoelectric stack was then heated at 400 °C for 15 minutes in an atmospheric environment. After heating, an evaluation was performed to see whether a detachment having a circle equivalent diameter of 30 μm or more occurred at the boundary between the KNN film and the top adhesion layer of each piezoelectric stack. The evaluation of the occurrence of detachment was performed by observing the top face of the top electrode film of each piezoelectric stack obtained from Samples 1 to 4 with a differential interference contrast microscope (Digital Microscope DSX-510, manufactured by Olympus Corporation). In addition, the top face of the top electrode film of each piezoelectric stack after heating was observed in an arbitrary field of view of 400 μm × 400 μm using a differential interference contrast microscope (Digital Microscope DSX-510, manufactured by Olympus Corporation), and the number of detachments each having a circle equivalent diameter of 10 μm or more within the arbitrary field of view was counted for evaluation.

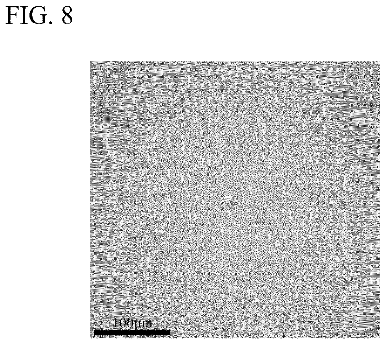

In the piezoelectric stacks obtained from Samples 1, 3, and 4, no detachments having a circle equivalent diameter of 30 μm or more were observed. In addition, in the piezoelectric stacks obtained from Samples 1, 3, and 4, detachments each having a circle equivalent diameter of 10 μm or more were sometimes observed, but the number thereof was very small, no more than 20, in any field of view of approximately 160,000 μm². FIG. 8 shows a differential interference contrast image of an arbitrary field of view of the piezoelectric stack obtained from Sample 1. For example, in FIG. 8, the number of detachments each having a circle equivalent diameter of 10 μm or more is only one in a field of view of approximately 160,000 μm².

In the piezoelectric stack of Sample 2, detachments having a circle equivalent diameter of 30 μm or more were observed, as shown in FIG. 5(a), and more than 20 detachments each having a circle equivalent diameter of 10 μm or more were also observed.

In this way, by preparing a stacked wafer by depositing a KNN film, applying a photoresist to the top face of the KNN film, and then removing the photoresist (without patterning), and depositing a top adhesion layer and a top electrode film on the KNN film after removing the photoresist, it can be found that the occurrence of partial detachment at the boundary between the KNN film and the top adhesion layer (top electrode) of the stacked wafer, and hence of the piezoelectric stack obtained from the stacked wafer, can be suppressed.

Preferable Embodiments of the Present Disclosure

Preferable embodiments of the present disclosure will be described below as supplementary descriptions.

(Supplementary Description 1)

According to an embodiment of the present disclosure, provided is a piezoelectric stack including:

a substrate;
a piezoelectric film deposited on the substrate, the piezoelectric film being constituted from an alkali niobium oxide, the alkali niobium oxide containing potassium, sodium, niobium, and oxygen and having a perovskite structure; and
a top electrode deposited on the piezoelectric film, wherein
in a case in which the piezoelectric stack is subjected to a heat treatment at 400 °C for 15 minutes in an atmospheric environment and then observed, no detachment having a circle equivalent diameter of 30 μm or more is observed at a boundary between the piezoelectric film and the top electrode.

(Supplementary Description 2)

The piezoelectric stack according to Supplementary Description 1, wherein, preferably
in a case in which, after the heat treatment, a top face of the top electrode is observed with a differential interference contrast microscope in a field of view of 400 μm × 400 μm, the number of detachments each having a circle equivalent diameter of 10 μm or more is no more than 20 in the field of view.

(Supplementary Description 3)

According to another embodiment of the present disclosure, provided is a piezoelectric stack including:

a substrate;
a piezoelectric film deposited on the substrate, the piezoelectric film being constituted from an alkali niobium oxide, the alkali niobium oxide containing potassium, sodium, niobium, and oxygen and having a perovskite structure; and
a top electrode deposited on the piezoelectric film, wherein
in a case in which the piezoelectric stack is subjected to a heat treatment at 400 °C for 15 minutes in an atmospheric environment, and then a top face of the top electrode is observed with a differential interference contrast microscope in a field of view of 400 μm × 400 μm, the number of detachments each having a circle equivalent diameter of 10 μm or more is no more than 20 in the field of view.

(Supplementary Description 4)

According to another embodiment of the present disclosure, provided is a piezoelectric stacked wafer including:

a substrate having a diameter of 100 mm or more;

a piezoelectric film deposited on the substrate, the piezoelectric film being constituted from an alkali niobium oxide, the alkali niobium oxide containing potassium, sodium, niobium, and oxygen and having a perovskite structure; and

a top electrode deposited on the piezoelectric film, wherein

in a case in which the piezoelectric stacked wafer is subjected to a heat treatment at 400 °C for 15 minutes in an atmospheric environment and then observed, no detachment having a circle equivalent diameter of 30 μm or more is observed at a boundary between the piezoelectric film and the top electrode in an area other than an area that is 5 mm from the outer periphery of the substrate.

(Supplementary Description 5)

According to another embodiment of the present disclosure, provided is a piezoelectric stack manufacturing method including:

preparing a substrate on which a piezoelectric film has been deposited, the piezoelectric film being constituted from an alkali niobium oxide containing potassium, sodium, niobium, and oxygen;

applying a photoresist to a surface (entire surface) of the piezoelectric film;

removing the photoresist from the surface of the piezoelectric film (without patterning the photoresist); and

depositing a top electrode on the surface of the piezoelectric film after the photoresist is removed.

(Supplementary Description 6)

The method according to Supplementary Description 5, wherein preferably the method further includes, after depositing the top electrode, performing a designated treatment on the piezoelectric stack while heating the substrate at a temperature of 400 °C or higher (forming a designated film on at least a portion of the top electrode).

Reference Signs List

| 1 | Substrate |
| 2 | Bottom electrode film |
| 3 | Piezoelectric film |
| 4 | Top electrode film |
| 6 | Bottom adhesion layer |
| 7 | Top adhesion layer |
| 8 | Insulating film |
| 9a, 9b | Metal wiring |
| 10 | Piezoelectric stacked wafer |
| 10A | Piezoelectric stack |

**Claims**

1.  A piezoelectric stack comprising:

    a substrate;

    a piezoelectric film deposited on the substrate, the piezoelectric film being constituted from an alkali niobium oxide, the alkali niobium oxide containing potassium, sodium, niobium, and oxygen and having a perovskite structure; and

    a top electrode deposited on the piezoelectric film, wherein

    in a case in which the piezoelectric stack is subjected to a heat treatment at 400 °C for 15 minutes in an atmospheric environment and then observed, no detachment having a circle equivalent diameter of 30 μm or more is observed at a boundary between the piezoelectric film and the top electrode.

2.  The piezoelectric stack according to Claim 1, wherein, in a case in which, after the heat treatment, a top face of the top electrode is observed with a differential interference contrast microscope in a field of view of 400 μm × 400 μm, the number of detachments each having a circle equivalent diameter of 10 μm or more is no more than 20 in the field of view.

3. A piezoelectric stack comprising:

   a substrate;
   a piezoelectric film deposited on the substrate, the piezoelectric film being constituted from an alkali niobium oxide, the alkali niobium oxide containing potassium, sodium, niobium, and oxygen and having a perovskite structure; and
   a top electrode deposited on the piezoelectric film, wherein
   in a case in which the piezoelectric stack is subjected to a heat treatment at 400 °C for 15 minutes in an atmospheric environment, and then a top face of the top electrode is observed with a differential interference contrast microscope in a field of view of 400 $\mu$m $\times$ 400 $\mu$m, the number of detachments each having a circle equivalent diameter of 10 $\mu$m or more is no more than 20 in the field of view.

4. A piezoelectric stacked wafer comprising:

   a substrate having a diameter of 100 mm or more;
   a piezoelectric film deposited on the substrate, the piezoelectric film being constituted from an alkali niobium oxide, the alkali niobium oxide containing potassium, sodium, niobium, and oxygen and having a perovskite structure; and
   a top electrode deposited on the piezoelectric film, wherein
   in a case in which the piezoelectric stacked wafer is subjected to a heat treatment at 400 °C for 15 minutes in an atmospheric environment and then observed, no detachment having a circle equivalent diameter of 30 $\mu$m or more is observed at a boundary between the piezoelectric film and the top electrode in an area other than an area that is 5 mm from the outer periphery of the substrate.

5. A piezoelectric stack manufacturing method comprising:

   preparing a substrate on which a piezoelectric film has been deposited, the piezoelectric film being constituted from an alkali niobium oxide containing potassium, sodium, niobium, and oxygen;
   applying a photoresist to a surface of the piezoelectric film;
   removing the photoresist from the surface of the piezoelectric film; and
   depositing a top electrode on the surface of the piezoelectric film after the photoresist is removed.

FIG. 1

FIG. 2

## FIG. 3

## FIG. 4

# FIG. 5

(a)

100μm

(b)

A————————A

(c)

FIG. 6

FIG. 7

FIG. 8

## INTERNATIONAL SEARCH REPORT

| International application No. |
|---|
| **PCT/JP2023/045475** |

---

**A. CLASSIFICATION OF SUBJECT MATTER**

*H10N 30/853*(2023.01)i; *C23C 14/08*(2006.01)i; *C23C 14/58*(2006.01)i; *H10N 30/20*(2023.01)i; *H10N 30/076*(2023.01)i; *H10N 30/082*(2023.01)i

FI: H10N30/853; H10N30/076; H10N30/20; H10N30/082; C23C14/08 K; C23C14/58 A

According to International Patent Classification (IPC) or to both national classification and IPC

---

**B. FIELDS SEARCHED**

Minimum documentation searched (classification system followed by classification symbols)

H10N30/853; C23C14/08; C23C14/58; H10N30/20; H10N30/076; H10N30/082

---

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

---

Electronic data base consulted during the international search (name of data base and, where practicable, search terms used)

---

**C. DOCUMENTS CONSIDERED TO BE RELEVANT**

| Category* | Citation of document, with indication, where appropriate, of the relevant passages | Relevant to claim No. |
|---|---|---|
| X | JP 2018-83316 A (KONICA MINOLTA, INC.) 31 May 2018 (2018-05-31) paragraphs [0043], [0048]-[0053], fig. 4, 5 | 5 |
| A | | 1-4 |
| A | JP 2017-188550 A (SHIN-ETSU CHEMICAL CO., LTD.) 12 October 2017 (2017-10-12) entire text, all drawings | 1-5 |
| A | JP 2011-29591 A (HITACHI CABLE LTD.) 10 February 2011 (2011-02-10) entire text, all drawings | 1-5 |

---

☐ Further documents are listed in the continuation of Box C.　　☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **20 February 2024** | **05 March 2024** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 Japan | |
| | Telephone No. |

Form PCT/ISA/210 (second sheet) (July 2022)

## INTERNATIONAL SEARCH REPORT
### Information on patent family members

International application No.

**PCT/JP2023/045475**

| Patent document cited in search report | | | Publication date (day/month/year) | Patent family member(s) | | | Publication date (day/month/year) |
|---|---|---|---|---|---|---|---|
| JP | 2018-83316 | A | 31 May 2018 | (Family: none) | | | |
| JP | 2017-188550 | A | 12 October 2017 | US | 2019/0051525 | A1 | |
| | | | | entire text, all drawings | | | |
| | | | | WO | 2017/175755 | A1 | |
| | | | | EP | 3442005 | A1 | |
| | | | | CN | 108885972 | A | |
| | | | | KR | 10-2018-0131542 | A | |
| JP | 2011-29591 | A | 10 February 2011 | US | 2010/0320871 | A1 | |
| | | | | entire text, all drawings | | | |
| | | | | CN | 101931046 | A | |

Form PCT/ISA/210 (patent family annex) (July 2022)

**EP 4 686 371 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017076730 A

- JP 2008159807 A